# EUROPÄISCHE PATENTSCHRIFT

(11) **EP 2 775 267 B1**
(45) Veröffentlichungstag und Bekanntmachung des Hinweises auf die Patenterteilung: **25.04.2018**
(21) Anmeldenummer: 14000507.5
(22) Anmeldetag: 13.02.2014
(51) Int. Cl.: G01D 5/14, H02P 6/16, H02K 11/00, G01P 3/48, H02K 11/20, H02P 6/17, G01D 5/244

(54) **Verfahren zur Ermitting eines Polradwinkels**
Method for determining a pole wheel angle
Procédé de détermination d'un angle de rotation de rotor

(30) Priorität: 08.03.2013 AT 1832013
(43) Veröffentlichungstag der Anmeldung: 10.09.2014
(73) Patentinhaber: GE Jenbacher GmbH & Co OG, 6200 Jenbach (AT)
(72) Erfinder: Niedrist, Helmut, 5026 Salzburg (AT)
(74) Vertreter: Torggler & Hofinger Patentanwälte

(56) Entgegenhaltungen:
- EP-A1- 1 416 623
- DE-A1-102008 001 408
- DE-A1-102010 001 248

## Beschreibung

Die Erfindung betrifft ein Verfahren zur Ermittlung eines Polradwinkels eines mit einem Energieversorgungsnetz elektrisch verbundenen Synchrongenerators mit einem Rotor, wobei wenigstens eine Drehzahlmesseinrichtung vorgesehen ist, die während einer Umdrehung des Rotors, insbesondere während jeder Umdrehung des Rotors, wenigstens ein Drehzahlsignal an eine Auswerteeinheit meldet, wobei eine Frequenzmesseinrichtung vorgesehen ist, die je Periodendauer eines Spannungssignals des Energieversorgungsnetzes ein Frequenzsignal an die Auswerteeinheit meldet, wobei von der Auswerteeinheit eine Zeitdauer zwischen Meldung des Drehzahlsignals und Meldung des Frequenzsignals ermittelt wird, wobei abhängig von der ermittelten Zeitdauer auf den Polradwinkel geschlossen wird.

Beim Einsatz von mit einem Energieversorgungsnetz elektrisch verbundenen Synchrongeneratoren wird oftmals ein kapazitiver Betrieb der Synchrongeneratoren gefordert. Dabei soll die abgegebene kapazitive Blindleistung des Synchrongenerators soweit erhöht werden, dass bspw. ein Wirkfaktor von cos ϕ < 0,95 cap. erreicht werden kann. Eine Erhöhung der kapazitiven Blindleistung kann durch eine Untererregung des Synchrongenerators erreicht werden, bei der man sich jedoch zwangsläufig der Stabilitätsgrenze des Synchrongenerators nähert.

Ein Maß für die Stabilität des Synchrongeneratorbetriebs ist dabei bekannterweise der Polradwinkel. Bei mit einem Energieversorgungsnetz verbundenen Synchrongeneratoren drückt der Polradwinkel bzw. Lastwinkel die Abweichung der Magnetpole am Rotor des Synchrongenerators von den Magnetpolen am Stator des Synchrongenerators aus. Die Magnetpole am Rotor werden dabei üblicherweise durch eine Gleichstrom-gespeiste Erregerwicklung am Rotor erzeugt und die Magnetpole am Stator des Synchrongenerators werden durch die an entsprechende Wicklungen am Stator angelegte elektrische Spannung des Energieversorgungsnetzes, welches typischerweise dreiphasig ausgeführt ist, erzeugt. Der Polradwinkel beschreibt somit im Zeigermodell den Winkel zwischen der Ständerspannung und der Rotorspannung bzw. Polradspannung, wobei die Rotorspannung im Synchrongeneratorbetrieb der Ständerspannung voraus eilt. Bei steigender Belastung durch das Energieversorgungsnetz, d.h. bei erhöhter Energiebereitstellung durch den Synchrongenerator, erhöht sich dieser Polradwinkel. Wird der Polradwinkel zu groß, führt dies zu einer Instabilität des Synchrongenerators.

Zur Ermittlung des Polradwinkels ist bspw. aus der DE 10 2010 001 248 A1 bekannt, über die erfasste Zeit zwischen dem Auftreten eines Drehzahlsignals vom Rotor des Synchrongenerators und dem Auftreten eines Spannungsnulldurchlaufs eines Spannungssignals des Eriergieversorgungsnetzes auf den Polradwinkel zu schließen. Für das darin beschriebene Verfahren ist jedoch eine aufwändige Kalibrierung notwendig. So müssen bestimmte relevante Punkte innerhalb des Spannungsverlaufs einer Solldrehposition des Rotors zugeordnet werden und in weiterer Folge ein Sensor der Drehzahlmesseinrichtung entsprechend am Rotor angebracht werden, dass dieser bei Erreichen der Solldrehposition des Rotors ein Ausgangssignal erzeugt. Mit anderen Worten muss bei jeder Kalibrierung der Sensor der Drehzahlmesseinrichtung genau an einen zu bestimmenden Ort im Synchrongenerator platziert werden, damit das Verfahren funktioniert.

Aufgabe der Erfindung ist es, ein gegenüber dem Stand der Technik verbessertes Verfahren zur Ermittlung des Polradwinkels anzugeben. Insbesondere soll die Kalibrierung des Verfahrens vereinfacht werden.

Diese Aufgabe wird erfindungsgemäß durch die Merkmale des Patentanspruchs 1 gelöst. Vorteilhafte Ausgestaltungen der Erfindungen sind in den abhängigen Ansprüchen angegeben.

Gemäß der Erfindung ist also vorgesehen, dass zur Kalibrierung des Verfahrens die ermittelte Zeitdauer nach erfolgter Synchronisation des Synchrongenerators mit dem Energieversorgungsnetz und im Wesentlichen ohne Lastbeaufschlagung des Synchrongenerators als Leerlaufzeitdauer in der Auswerteeinheit abgespeichert wird, wobei zur Ermittlung des Polradwinkels eine Differenzzeit aus ermittelter Zeitdauer abzüglich Leerlaufzeitdauer gebildet wird, wobei abhängig von der Differenzzeit auf den Polradwinkel geschlossen wird.

Bei fehlender Lastbeaufschlagung des Synchrongenerators - also bei Leerlauf des Synchrongenerators - beträgt der Polradwinkel 0 Grad. Somit kann die nach einer erfolgten Synchronisation des Synchrongenerators mit dem Energieversorgungsnetz ermittelte Zeitdauer zwischen Meldung des Drehzahlsignals und Meldung des Frequenzsignals bei Leerlauf als ein Referenzwert für die nachfolgende Ermittlung des Polradwinkels unter Last des Synchrongenerators herangezogen werden. Diese bei Leerlauf ermittelte Zeitdauer wird als Leerlaufzeitdauer in der Auswerteeinheit abgespeichert. Für die Ermittlung des vorherrschenden Polradwinkels wird diese Referenzzeit bzw. Leerlaufzeitdauer jeweils von der ermittelten Zeitdauer abgezogen, wodurch das vorgeschlagene Verfahren unabhängig von der geographischen Platzierung eines Sensors der Drehzahlmesseinrichtung ist, d.h. die Drehzahlmesseinrichtung kann beliebig angeordnet werden. Mit anderen Worten entfällt bei der Kalibrierung des vorgeschlagenen Verfahrens das Ermitteln eines genauen Ortes, an dem der Sensor der Drehzahlmesseinrichtung platziert werden muss, damit das Verfahren funktioniert. Ein Sensor der Drehzahlmesseinrichtung kann an beliebiger Stelle platziert werden, da durch die Ermittlung und Verwendung der Leerlaufzeitdauer zur Polradwinkelermittlung eine Korrektur des Verfahrens bezüglich der Platzierung des Sensors erfolgt.

Beim Frequenzsignal kann es sich um den jeweiligen Maximalwert der Ständerspannung je Periodendauer des Spannungssignals oder vorzugsweise um den jeweiligen (z.B, positiven) Spannungsnulldurchgang handeln. Günstig ist, wenn pro Periodendauer des Spannungssignals genau ein Frequenzsignal an die Auswerteeinheit gemeldet wird. In diesem Fall wird bei einem Energieversorgungsnetz mit einer Betriebsfrequenz von 50 Hertz (Hz) ein Frequenzsignal alle 20 Millisekunden (ms) an die Auswerteeinheit gemeldet.

Das vorgeschlagene Verfahren funktioniert auch unabhängig von der Polanzahl des Synchrongenerators und von der Anzahl der Sensoren der Drehzahlmesseinrichtung, da durch die vorgeschlagene Kalibrierung immer eine Korrektur in Bezug auf die vorherrschenden Gegebenheiten durchgeführt wird. So wird bspw. bei einem zweipoligen Synchrongenerator mit einem an beliebiger Stelle positionierten Drehzahlsensor am Rotor des Synchrongenerators eine Polradwinkelermittlung je Periodendauer des Spannungssignals durchgeführt. Bei einem vierpoligen Synchrongenerator mit nur einem Drehzahlsensor am Rotor erfolgt bspw. eine Polradwinkelermittlung je zwei Periodendauern des Spannungssignals. Wenn man einen vierpoligen Synchrongenerator bspw. mit zwei um 180 Grad versetzt angeordnete Drehzahlsensoren am Rotor ausstattet, so würde wiederum eine Polradwinkelermittlung je Periodendauer des Spannungssignals erfolgen. In all diesen Varianten führt die vorgeschlagene Kalibrierung zu einer automatischen Korrektur in Bezug auf die vorhandenen Gegebenheiten.

Gemäß einer besonders bevorzugten Ausführungsform kann vorgesehen sein, dass der Rotor mit einer Motorwelle einer Brennkraftmaschine, insbesondere eines Gasmotors, mechanisch starr verbunden ist, wobei die wenigstens eine Drehzahlmesseinrichtung je Umdrehung der Motorwelle oder einer Nockenwelle der Brennkraftmaschine das wenigstens eine Drehzahlsignal an die Auswerteeinheit meldet. Dies hat den Vorteil, dass üblicherweise bei Brennkraftmaschinen bereits vorhandene Drehzahlmesseinrichtungen als Signalgeber für das Drehzahlsignal verwendet werden können. So können bspw. an der Kurbelwelle oder Nockenwelle der Brennkraftmaschine angeordnete Sensoren das Drehzahlsignal an die Auswerteeinheit melden. Auch hierbei kann durch die vorgeschlagene Kalibrierung darauf verzichtet werden, die entsprechenden Sensoren an genau definierte Orte platzieren zu müssen.

Mit anderen Worten kann vorgesehen sein, dass die wenigstens eine Drehzahlmesseinrichtung einen Sensor umfasst, wobei der Sensor entlang eines Umfangs des Rotors oder entlang eines Umfangs der Motorwelle beliebig anordenbar ist und dass die wenigstens eine Drehzahlmesseinrichtung einen mit dem Sensor zusammenwirkenden Signalgeber umfasst, wobei der Signalgeber entlang eines Umfangs eines Stators des Synchrongenerators oder an einem Gehäuse der Brennkraftmaschine beliebig anordenbar ist.

Darüber hinaus ist es durch die vorgeschlagene Kalibrierung auch möglich, einen Sensor bzw. Pick-up der Nockenwelle der Brennkraftmaschine als Signalgeber für das Drehzahlsignal heranzuziehen. Die Periodendauer des Spannungssignals beträgt bei einem Energieversorgungsnetz mit einer Betriebsfrequenz von 50 Hz 20 ms. Die Nockenwelle der Brennkraftmaschine kann bspw. mit 750 Umdrehungen pro Minute rotieren. Ein an der Nockenwelle angeordneter Sensor würde dann lediglich alle 80 ms ein Drehzahlsignal abgeben. Da jedoch vorgesehen sein kann, dass immer nur das gemeldete Drehzahlsignal der Auslöser für die Ermittlung der Zeitdauer zwischen der Meldung des Drehzahlsignals und der Meldung des Frequenzsignals ist, würde in diesem Fall eine Polradwinkelermittlung je vier Periodendauern des Spannungssignals erfolgen. Wiederum würde hier die Kalibrierung dafür sorgen, dass die Ermittlung des Polradwinkels ohne weitere mechanische Eingriffe oder Abstimmungen möglich ist.
Generell kann bei Synchrongeneratoren mit mehreren Polen p vorgesehen sein, dass die Ermittlung des tatsächlichen Polradwinkels nur einmal pro Umdrehung des Rotors erfolgt, also alle p Periodendauern. Beispielsweise würde eine Drehzahlmesseinrichtung an einem Rotor mit 750 Umdrehungen pro Minute nur alle 80 ms ein Signal liefern, und es würde bei 50 Hz Netzfrequenz nur jeder vierte Spannungsnulldurchgang gewertet werden. Durch Erhöhen der Anzahl der Drehzahlmesseinrichtungen bzw. Sensoren am Rotor kann insbesondere für langsam laufende Synchrongeneratoren die Genauigkeit der Messung beliebig erhöht werden. Mehrere Sensoren (Pick-ups) am Rotor sollten vorzugsweise gleichmäßig am Umfang verteilt werden, jedoch kann auch eine beliebige Anordnung der Drehzahlmesseinrichtungen mit individueller Kalibrierung wie vorgeschlagen erfolgen.

In einer bevorzugten Ausführungsform der Erfindung kann vorgesehen sein, dass die Differenzzeit proportional in Grad Polradwinkel umgerechnet wird, wobei ein Wert der Differenzzeit von im Wesentlichen 0 Sekunden einem Polradwinkel von 0 Grad und ein Wert der Differenzzeit von im Wesentlichen einem Viertel der Periodendauer des Spannungssignals des Energieversorgungsnetzes einem Polradwinkel von 90 Grad entspricht. Ein Polradwinkel von 90 Grad stellt die theoretische Polschlupfgrenze dar. Wird diese überschritten, führt dies zu einer Instabilität des Synchrongenerators, bei der die von der Brennkraftmaschine über die mit dem Rotor verbundene Motorwelle eingebrachte mechanische Leistung nicht mehr wie gewünscht in elektrische Leistung umgewandelt werden kann und die Brennkraftmaschine beginnt zu schlüpfen.

Bei einem Energieversorgungsnetz mit einer Betriebsfrequenz von 50 Hz beträgt die Periodendauer des Spannungssignals 20 ms. Dies entspricht im Zeigerdiagramm einem vollen Umlauf des Spannungszeigers von 360 Grad. Ein Viertel dieser Periodendauer (entspricht 90 Grad) sind in einem solchen Netz 5 ms. Eine ermittelte Differenzzeit von 5 ms würde daher einem Polradwinkel von 90 Grad entsprechen.

Bei einem Energieversorgungsnetz mit einer Betriebsfrequenz von 60 Hz beträgt die Periodendauer des Spannungssignals 16,667 ms. Ein Viertel davon sind 4,167 ms. Eine ermittelte Differenzzeit von 4,167 ms würde daher in einem solchen Netz einem Polradwinkel von 90 Grad entsprechen.

Durch den Einbezug der vorherrschenden Betriebsfrequenz des Energieversorgungsnetzes kann somit das vorgeschlagene Verfahren in Verbindung mit Energieversorgungsnetzen mit unterschiedlichen Betriebsfrequenzen eingesetzt werden.

Eine besondere Ausführungsvariante sieht vor, dass bei einem ermittelten Polradwinkel von mehr als 5 Grad, vorzugsweise mehr als 7 Grad, zur Signalisierung eines drohenden Polschlupfes von der Auswerteeinheit ein Warnsignal ausgegeben wird. Dadurch kann bereits frühzeitig, noch vor Eintreten eines tatsächlichen Polschlupfes - der beträchtliche Schäden an Synchrongenerator und Brennkraftmaschine hervorrufen kann - rechtzeitig reagiert werden und bspw. der Synchrongenerator vom Energieversorgungsnetz getrennt werden oder die Erregerspannung erhöht werden.

Da die üblicherweise von einem Synchrongeneratorhersteller angegebene Ortskurve mit der Polschlupfgrenze nur für eine bestimmte Nennspannung gilt und überdies oftmals Reserven unbekannter Größe enthält, kann man durch Ermittlung des tatsächlich vorherrschenden Polradwinkels gemäß dem vorgeschlagenen Verfahren den Synchrongenerator näher an seiner Polschlupfgrenze betreiben. Somit kann der Synchrongenerator im kapazitiven Betriebsbereich besser ausgenutzt werden, ohne den Synchrongenerator teuer überdimensionieren zu müssen.

Da die Periodendauern der Spannungssignale des Energieversorgungsnetzes gewissen Schwankungen unterliegen können, ist es für die Genauigkeit der Polradwinkelermittlung von Vorteil, diese Schwankungen in die Ermittlung des Polradwinkels einzubeziehen.

Daher ist besonders jene Ausführungsform der Erfindung vorteilhaft, bei der zur Berücksichtigung einer Netzfrequenzschwankung des Spannungssignals des Energieversorgungsnetzes bei oder während der Ermittlung der Zeitdauer zwischen Meldung des Drehzahlsignals und Meldung des Frequenzsignals eine tatsächliche Periodendauer des Spannungssignals ermittelt wird, wobei wenigstens ein Korrekturfaktor gebildet aus einer vorgebbaren theoretischen Periodendauer gebrochen durch die tatsächliche Periodendauer ermittelt wird, wobei die ermittelte Zeitdauer mit dem wenigstens einen Korrekturfaktor multipliziert wird.

Die vorgebbare theoretische Periodendauer kann dabei bspw. bei einem Energieversorgungsnetz mit einer Betriebsfrequenz von 50 Hz 20 ms betragen und bei einem Energieversorgungsnetz mit einer Betriebsfrequenz von 60 Hz 16,667 ms. Die tatsächliche Periodendauer des Spannungssignals kann vorzugsweise durch Messung einer Zeitdifferenz zwischen zwei aufeinanderfolgenden Frequenzsignalen ermittelt werden.

Eine besondere Variante der Erfindung kann dabei vorsehen, dass ein Korrekturfaktor bei oder während der Ermittlung der Leerlaufzeitdauer gebildet wird, wobei die Leerlaufzeitdauer mit dem Korrekturfaktor multipliziert wird und als normierte Leerlaufzeitdauer in der Auswerteeinheit abgespeichert wird. Darüber hinaus kann vorgesehen sein, dass ein Korrekturfaktor bei oder während der Ermittlung der Differenzzeit gebildet wird, wobei eine normierte Zeitdauer durch Multiplikation der ermittelten Zeitdauer mit dem Korrekturfaktor gebildet wird, wobei zur Ermittlung des Polradwinkels eine normierte Differenzzeit aus normierter Zeitdauer abzüglich normierter Leerlaufzeitdauer gebildet wird, wobei abhängig von der normierten Differenzzeit auf den Polradwinkel geschlossen wird.

Mit anderen Worten kann zur Berücksichtigung von Schwankungen der Periodendauern der Spannungssignale des Energieversorgungsnetzes zunächst bei der Kalibrierung des vorgeschlagenen Verfahrens die tatsächlich vorhandene Periodendauer des Spannungssignals erfasst werden, die ermittelte Zeitdauer zwischen Meldung des Drehzahlsignals und Meldung des Frequenzsignals mittels Korrekturfaktor in Bezug auf die vorgebbare theoretische Periodendauer normiert werden und als normierte Leerlaufzeitdauer in der Auswerteeinheit abgespeichert werden. Zur Ermittlung eines jeweiligen Polradwinkels kann dann auch bei den folgenden Ermittlungen der Zeitdauern ebenfalls die jeweils tatsächlich vorhandene Periodendauer des Spannungssignals erfasst werden und die jeweilige ermittelte Zeitdauer mittels Korrekturfaktor auf die vorgebbare theoretische Periodendauer normiert werden. Die Differenz aus normierter Zeitdauer und normierter Leerlaufzeitdauer ergibt eine normierte Difterenzzeit in Bezug auf die vorgebbare theoretische Periodendauer, aus der auf den Polradwinkel geschlossen werden kann.

Weitere Einzelheiten und Vorteile der vorliegenden Erfindung werden anhand der nachfolgenden Figurenbeschreibung erläutert. Darin zeigen:
- Fig. 1: einen mit einer Brennkraftmaschine verbundenen Synchrongenerator und eine Auswerteeinheit zur Ermittlung des Polradwinkels,
- Fig. 2: einen Synchrongenerator und eine Auswerteeinheit zur Ermittlung des Polradwinkels,
- Fig. 3a bis 3e: zeitliche Verläufe eines Spannungssignals, eines Frequenzsignals sowie von Drehzahlsignalen bei verschiedenen Betriebsarten eines Synchrongenerators,
- Fig. 4a: ein Zeigerdiagramm eines Synchrongenerators mit beliebig angeordneter Drehzahlmesseinrichtung im Leerlauf und
- Fig. 4b: ein Zeigerdiagramm gemäß Fig. 4a bei Last am Synchrongenerator.

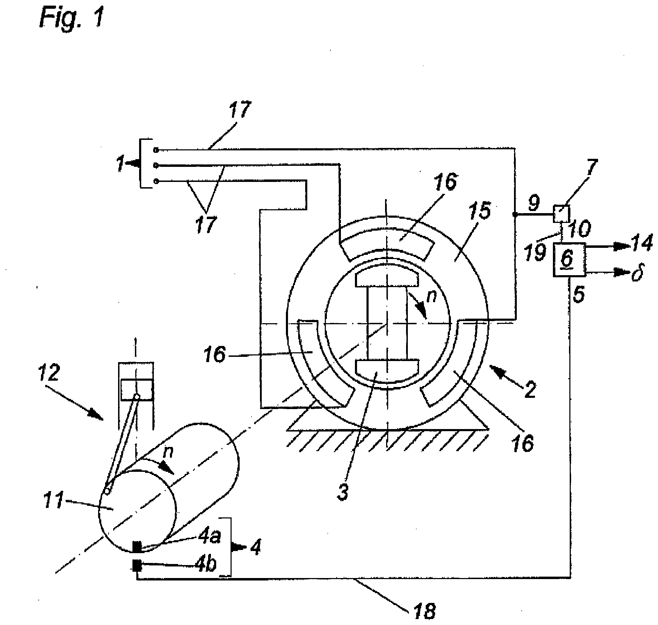

Figur 1 zeigt schematisch einen Synchrongenerator 2, umfassend einen Stator 15 und einen relativ zum Stator 15 drehbaren Rotor 3. Am Stator 15 sind drei Statorwicklungen 16 in bekannter Art und Weise angeordnet und mit den drei Phasen 17 eines dreiphasigen Energieversorgungsnetzes 1 verbunden. Der Rotor 3 ist in diesem Beispiel zweipolig ausgeführt und starr bzw. drehfest mit einer Motorwelle 11 einer Brennkraftmaschine 12 - welche bspw. als stationärer Gasmotor ausgeführt sein kann - verbunden. Die Motorwelle 11 rotiert mit einer Drehzahl n. An der. Brennkraftmaschine 12 ist eine Drehzahlmesseinrichtung 4 angeordnet. Die Drehzahlmesseinrichtung 4 ist als ein im Stand der Technik bekannter Drehzahlsensor ausgebildet, der einen an der Motorwelle 11 angeordneten Sensor bzw. Pick-up 4a und einen lagestabil am Gehäuse der Brennkraftmaschine 12 angeordneten Signalgeber 4b umfasst und bei jeder Umdrehung der Motorwelle 11 über eine erste Signalleitung 18 ein Drehzahlsignal 5 an eine Auswerteeinheit 6 meldet. Ebenso wird durch eine Frequenzmesseinrichtung 7, die mit einer Phase 17 des Energieversorgungsnetzes 1 verbunden ist, je Periodendauer τ eines Spannungssignals 9 der entsprechenden Phase 17 über eine zweite Signalleitung 19 ein Frequenzsignal 10 an die Auswerteeinheit 6 gemeldet.

Um nun den Polradwinkel δ zu ermitteln, wird zunächst zur Kalibrierung nach erfolgter Synchronisation des Synchrongenerators 2 mit dem Energieversorgungsnetz 1 und bei Leerlauf des Synchrongenerators 2 von der Auswerteeinheit 6 eine Zeitdauer T zwischen Meldung des Drehzahlsignals 5 und Meldung des Frequenzsignals 10 ermittelt und als Leerlaufzeitdauer T_{L} in der Auswerteeinheit 6 abgespeichert. Für diese Kalibrierung ist es wichtig, dass der Synchrongenerator 2 im Leerlauf - also im Wesentlichen ohne Lastbeaufschlagung - ist. Nach erfolgter Kalibrierung kann nun zur Ermittlung des Polradwinkels δ eine Differenzzeit T_{D} aus ermittelter Zeitdauer T zwischen Meldung des Drehzahlsignals 5 und Meldung des Frequenzsignals 10 abzüglich der abgespeicherten Leerlaufzeitdauer T_{L} gebildet werden, wobei abhängig von der Differenzzeit T_{D} auf den Polradwinkel δ geschlossen werden kann.

Bei Belastung des Synchrongenerators 2 erhöht sich der Polradwinkel δ auf theoretisch 90 Grad (theoretische Schlupfgrenze), da die Brennkraftmaschine 12 das Polrad bzw. den Rotor 3 im Generatorbetrieb des Synchrongenerators 2 nach vorne in Richtung der Rotationsrichtung der Motorwelle 11 drückt. Dabei tritt das Drehzahlsignal 5 im Vergleich zum Frequenzsignal 10 immer früher auf, wodurch sich die Zeitdauer T zwischen Meldung des Drehzahlsignals 5 und Meldung des Frequenzsignals 10 vergrößert, und zwar im Wesentlichen proportional zum sich einstellenden Polradwinkel δ.

Bei einem Energieversorgungsnetz 1 mit einer Betriebsfrequenz von 50 Hz und beim theoretischen Maximum eines Polradwinkels δ von 90 Grad wäre also die Zeitdauer T die Leerlaufzeitdauer T_{L} plus 5 ms. Generell kann daher die Differenzzeit T_{D} aus erfasster Zeitdauer T abzüglich der Leerlaufzeitdauer T_{L} gebildet werden und durch die Proportionalität zwischen der Differenzzeit T_{D} und dem Polradwinkel δ der Polradwinkel δ ermittelt werden. Wenn die Erfassung der Zeitdauer T mit einer hinreichenden Auflösung und Genauigkeit durchgeführt wird - z.B. mit einer Auflösung von etwa 0,1 ms - so kann der Polradwinkel δ im Wesentlichen auf einen Grad genau ermittelt werden. Bei einem Energieversorgungsnetz 1 mit einer Betriebsfrequenz von 50 Hz entspricht eine Differenzzeit T_{D} von 5 ms (ein Viertel der Periodendauer τ eines Spannungssignals 9) einem Polradwinkel δ von 90 Grad. Dementsprechend entspricht ein Polradwinkel δ von 1 Grad einer Differenzzeit T_{D} von 0,055 ms.

Der ermittelte Polradwinkel δ kann von der Auswerteeinheit 6 ausgegeben werden, z.B. an eine übergeordnete Steuerung oder Regelung. Um einen drohenden Polschlupf zu signalisieren, kann vorgesehen sein, dass bei einem ermittelten Polradwinkel δ von etwa 8 Grad von der Auswerteeinheit 6 ein Warnsignal 14 ausgegeben wird.

Generell kann die Drehzahlmesseinrichtung 4 auch an anderen Teilen der Brennkraftmaschine 12 - welche eine mechanische Rotationsfrequenz darstellen - oder am Synchrongenerator 2 angeordnet sein. So ist es beispielsweise denkbar, die Drehzahlmesseinrichtung 4 an einer Kurbelwelle oder Nockenwelle der Brennkraftmaschine 12 anzuordnen.

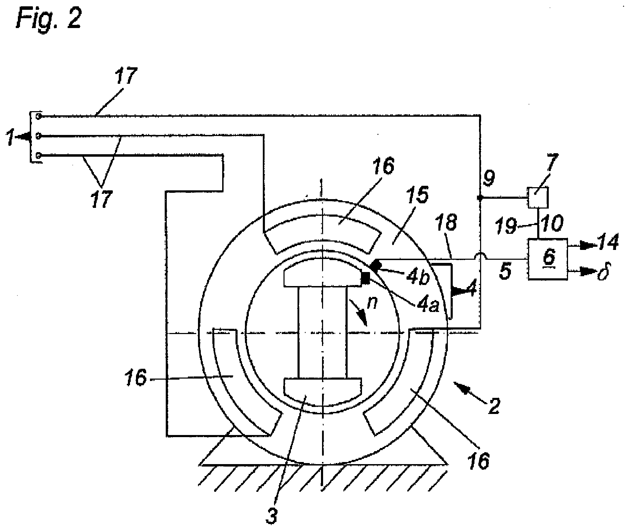

Figur 2 zeigt einen Synchrongenerator 2 gemäß Figur 1 mit dem Unterschied, dass die Drehzahlmesseinrichtung 4 in diesem Beispiel am Synchrongenerator 2 selbst angeordnet ist, anstatt wie in Figur 1 an der Brennkraftmaschine 12. Die Drehzahlmesseinrichtung 4 umfasst in diesem Beispiel einen Sensor bzw. Pick-up 4a, der am Rotor 3 angeordnet ist, sowie einen Signalgeber 4b, der am Stator 15 angeordnet ist. Der Rotor 3 rotiert mit einer Drehzahl n. Bei jedem Vorbeifahren des Pick-up 4a am Signalgeber 4b wird ein Drehzahlsignal 5 an die Auswerteeinheit 6 gemeldet.

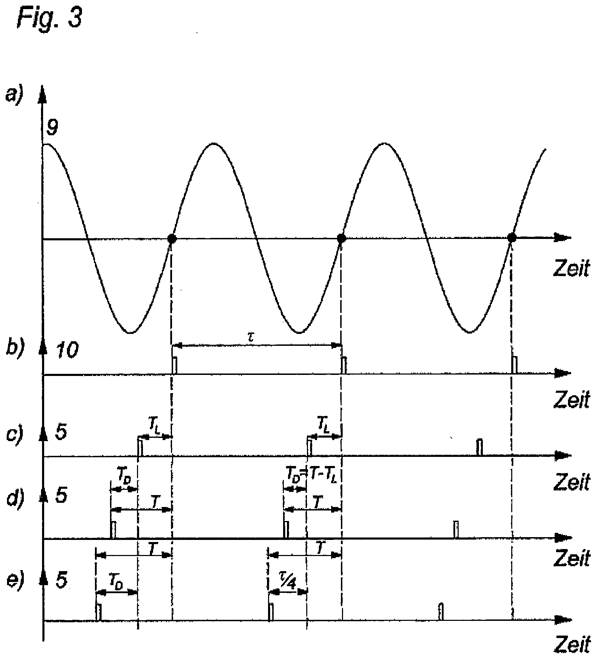

Figur 3a zeigt beispielhaft den Spannungsverlauf eines Spannungssignals 9 einer Phase 17 eines Energieversorgungsnetzes 1. Eine mit der Phase 17 verbundene Frequenzmesseinrichtung 7 (siehe Figur 1) liefert bei jedem positiven Nulldurchgang des Spannungssignals 9 ein Frequenzsignal 10 und meldet dieses an die Auswerteeinheit 6. Wie in Figur 3b zu sehen, wird somit je Periodendauer τ des Spannungssignals 9 ein Frequenzsignal 10 an die Auswerteeinheit 6 gemeldet.

Figur 3c zeigt den zeitlichen Verlauf eines von der Drehzahlmesseinrichtung 4 gemäß Figur 1 oder Figur 2 an die Auswerteeinheit 6 gemeldeten Signals 5 bei Leerlauf des Synchrongenerators 2. Je nach geographischer Anordnung der Drehzahlmesseinrichtung 4 ergibt sich bei Leerlauf eine bestimmte Leerlaufzeitdauer T_{L} zwischen Meldung des Drehzahlsignals 5 und Meldung des Frequenzsignals 10. Diese Leerlaufzeitdauer T_{L} kann in der Auswerteeinheit 6 abgespeichert werden und bei Lastbeaufschlagung des Synchrongenerators 2 zur Ermittlung des Polradwinkels δ herangezogen werden.

Figur 3d zeigt den zeitlichen Verlauf des Drehzahlsignals 5 gemäß Figur 3c unter Lastbeaufschlagung des Synchrongenerators 2. Unter Last stellt sich ein Polradwinkel δ ein, der sich dadurch äußert, dass das Drehzahlsignal 5 im Vergleich zum Leerlauf nunmehr früher gemeldet wird. Dadurch ergibt sich eine gegenüber Leerlauf veränderte Zeitdauer T zwischen Meldung des Drehzahlsignals 5 und Meldung des Frequenzsignals 10. Zur Ermittlung des Polradwinkels δ wird nunmehr die Leerlaufzeitdauer T_{L} von der ermittelten Zeitdauer T abgezogen, wodurch man eine Differenzzeit T_{D} erhält, welche dem Polradwinkel δ entspricht.

Figur 3e zeigt den zeitlichen Verlauf des Drehzahlsignals 5 gemäß Figur 3c bei der Schlupfgrenze, welche einem Polradwinkel von 90 Grad entspricht. Ein Polradwinkel δ von 90 Grad wiederum entspricht einer Differenzzeit T_{D} von einem Viertel der Periodendauer τ des Spannungssignals 9.

Die zeitlichen Verläufe der Figuren 3a bis 3e beziehen sich auf eine Konfiguration des vorgeschlagenen Verfahrens, bei der die Zeitdauer T von Meldung des Drehzahlsignals 5 bis Meldung des Frequenzsignals 10 ermittelt wird. Das vorgeschlagene Verfahren kann natürlich auch so konfiguriert werden, dass die Zeitdauer T von Meldung des Frequenzsignals 10 bis Meldung des Drehzahlsignals 5 ermittelt wird.

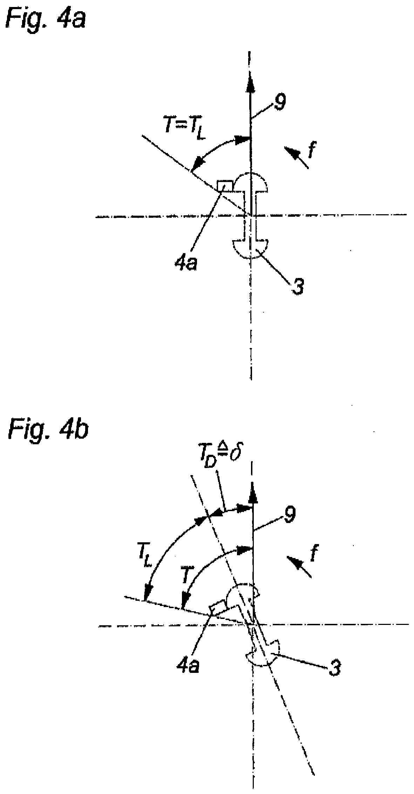

Figur 4a zeigt schematisch das Polrad bzw. den Rotor 3 eines Synchrongenerators 2 mit daran angeordnetem Pick-up 4a einer Drehzahlmesseinrichtung 4, überlagert mit einem Zeigerdiagramm des Spannungssignals 9 einer Phase 17 eines Energieversorgungsnetzes 1 bei Leerlauf. Der Pfeil mit dem Bezugszeichen f zeigt die Rotationsrichtung des Zeigerdiagramms an. Bei Leerlauf beträgt der Polradwinkel δ bekanntermaßen im Wesentlichen 0 Grad. Je nach geographischer Platzierung der Drehzahlmesseinrichtung 4 bzw. deren Pick-up 4a und Impulsgeber 4b ergibt sich zwischen Meldung des Drehzahlsignals 5 und Meldung des Frequenzsignals 10 eine Leerlaufzeitdauer T_{L}, welche in der Auswerteeinheit 6 abgespeichert werden kann.

Figur 4b zeigt die schematische Darstellung gemäß Figur 4a unter Lastbeaufschlagung des Synchrongenerators 2. Hierbei wird in bekannter Art und Weise das Polrad bzw. der Rotor 3 des Synchrongenerators 2 im Zeigerdiagramm gegenüber dem Zeiger des Spannungssignals 9 nach vorne in Richtung der Zeigerrotation f gedrückt. Dadurch ergibt sich eine gegenüber Leerlauf erhöhte Zeitdauer T zwischen Meldung des Drehzahlsignals 5 und Meldung des Frequenzsignals 10. Indem man von dieser ermittelten Zeitdauer T die Leerlaufzeitdauer T_{L} abzieht, erhält man die Differenzzeit T_{D}, welche dem Polradwinkel δ entspricht.

## Patentansprüche

1. Verfahren zur Ermittlung eines Polradwinkels (δ) eines mit einem Energieversorgungsnetz (1) elektrisch verbundenen Synchrongenerators (2) mit einem Rotor (3), wobei wenigstens eine Drehzahlmesseinrichtung (4) vorgesehen ist, die während einer Umdrehung des Rotors (3), insbesondere während jeder Umdrehung des Rotors (3), wenigstens ein Drehzahlsignal (5) an eine Auswerteeinheit (6) meldet, wobei eine Frequenzmesseinrichtung (7) vorgesehen ist, die je Periodendauer (τ) eines Spannungssignals (9) des Energieversorgungsnetzes (1) ein Frequenzsignal (10) an die Auswerteeinheit (6) meldet, wobei von der Auswerteeinheit (6) eine Zeitdauer (T) zwischen Meldung des Drehzahlsignals (5) und Meldung des Frequenzsignals (10) ermittelt wird, wobei abhängig von der ermittelten Zeitdauer (T) auf den Polradwinkel (δ) geschlossen wird, **dadurch gekennzeichnet, dass** zur Kalibrierung des Verfahrens die ermittelte Zeitdauer (T) nach erfolgter Synchronisation des Synchrongenerators (2) mit dem Energieversorgungsnetz (1) und im Wesentlichen ohne Lastbeaufschlagung des Synchrongenerators (2) als Leerlaufzeitdauer (T_{L}) in der Auswerteeinheit (6) abgespeichert wird, wobei zur Ermittlung des Polradwinkeis (δ) eine Differenzzeit (T_{D}) aus ermittelter Zeitdauer (T) abzüglich Leerlaufzeitdauer (T_{L}) gebildet wird, wobei abhängig von der Differenzzeit (T_{D}) auf den Polradwinkel (δ) geschlossen wird.

2. Verfahren nach Anspruch 1, **dadurch gekennzeichnet, dass** der Rotor (3) mit einer Motorwelle (11) einer Brennkraftmaschine (12), insbesondere eines Gasmotors, mechanisch starr verbunden ist, wobei die wenigstens eine Drehzahlmesseinrichtung (4) je Umdrehung der Motorwelle (11) oder einer Nockenwelle der Brennkraftmaschine (12) das wenigstens eine Drehzahlsignal (5) an die Auswerteeinheit (6) meldet.

3. Verfahren nach Anspruch 1 oder 2, **dadurch gekennzeichnet, dass** die wenigstens eine Drehzahlmesseinrichtung (4) einen Sensor (4a) umfasst, wobei der Sensor (4a) entlang eines Umfangs des Rotors (3) oder entlang eines Umfangs der Motorwelle (11) beliebig anordenbar ist.

4. Verfahren nach Anspruch 3, **dadurch gekennzeichnet, dass** die wenigstens eine Drehzahlmesseinrichtung (4) einen mit dem Sensor (4a) zusammenwirkenden Signalgeber (4b) umfasst, wobei der Signalgeber (4b) entlang eines Umfangs eines Stators (15) des Synchrongenerators (2) oder an einem Gehäuse der Brennkraftmaschine (12) beliebig anordenbar ist.

5. Verfahren nach einem der Ansprüche 1 bis 4, **dadurch gekennzeichnet, dass** die Differenzzeit (T_{D}) proportional in Grad Polradwinkel (δ) umgerechnet wird, wobei ein Wert der Differenzzeit (T_{D}) von im Wesentlichen 0 Sekunden einem Polradwinkel (δ) von 0 Grad und ein Wert der Differenzzeit (T_{D}) von im Wesentlichen einem Viertel der Periodendauer (τ) des Spannungssignals (9) des Energieversorgungsnetzes (1) einem Polradwinkel (δ) von 90 Grad entspricht.

6. Verfahren nach einem der Ansprüche 1 bis 5, **dadurch gekennzeichnet, dass** bei einem ermittelten Polradwinkel (δ) von mehr als 5 Grad, vorzugsweise mehr als 7 Grad, zur Signalisierung eines drohenden Polschluptes von der Auswerteeinheit (6) ein Warnsignal (14) ausgegeben wird.

7. Verfahren nach einem der Ansprüche 1 bis 6, **dadurch gekennzeichnet, dass** zur Berücksichtigung einer Netzfrequenzschwankung des Spannungssignals (9) des Energieversorgungsnetzes (1) bei oder während der Ermittlung der Zeitdauer (T) zwischen Meldung des Drehzahlsignals (5) und Meldung des Frequenzsignals (10) eine tatsächliche Periodendauer des Spannungssignals (9) ermittelt wird, wobei wenigstens ein Korrekturfaktor gebildet aus einer vorgebbaren theoretischen Periodendauer gebrochen durch die tatsächliche Periodendauer ermittelt wird, wobei die ermittelte Zeitdauer (T) mit dem wenigstens einen Korrekturfaktor multipliziert wird.

8. Verfahren nach Anspruch 7, **dadurch gekennzeichnet, dass** die tatsächliche Periodendauer des Spannungssignals (9) durch Messung einer Zeitdifferenz zwischen zwei aufeinanderfolgenden Frequenzsignalen (10) ermittelt wird.

9. Verfahren nach Anspruch 7 oder 8, **dadurch gekennzeichnet, dass** ein Korrekturfaktor bei oder während der Ermittlung der Leerlaufzeitdauer (T_{L}) gebildet wird, wobei die Leerlaufzeitdauer (T_{L}) mit dem Korrekturfaktor multipliziert wird und als normierte Leerlaufzeitdauer in der Auswerteeinheit (6) abgespeichert wird.

10. Verfahren nach einem der Ansprüche 7 bis 9, **dadurch gekennzeichnet, dass** ein Korrekturfaktor bei oder während der Ermittlung der Differenzzeit (T_{D}) gebildet wird, wobei eine normierte Zeitdauer durch Multiplikation der ermittelten Zeitdauer (T) mit dem Korrekturfaktor gebildet wird, wobei zur Ermittlung des Polradwinkels (δ) eine normierte Differenzzeit aus normierter Zeitdauer abzüglich normierter Leerlaufzeitdauer gebildet wird, wobei abhängig von der normierten Differenzzeit auf den Polradwinkel (δ) geschlossen wird.

## Claims

1. A method of determining a rotor displacement angle (δ) of a synchronous generator (2) having a rotor (3) and electrically connected to a power supply network (1), wherein there is provided at least one rotary speed measuring device (4) which during a revolution of the rotor (3), in particular during each revolution of the rotor (3), communicates at least one rotary speed signal (5) to an evaluation unit (6), wherein there is provided a frequency measuring device (7) which communicates a frequency signal (10) to the evaluation unit (6) for each period duration (τ) of a voltage signal (9) of the power supply network (1), wherein a time duration (T) between communication of the rotary speed signal (5) and communication of the frequency signal (10) is determined by the evaluation unit (6), wherein the rotor displacement angle (δ) is inferred in dependence on the determined time duration (T), **characterised in that** for calibration of the method the determined time duration (T) is stored after synchronisation of the synchronous generator (2) with the power supply network (1) has been effected and substantially without load application to the synchronous generator (2) as a no-load time duration (T_{L}) in the evaluation unit (6), wherein to determine the rotor displacement angle (δ) a differential time (T_{D}) is formed from the determined time duration (T) less the no-load time duration (T_{L}), wherein the rotor displacement angle (δ) is inferred in dependence on the differential time (T_{D}).

2. A method as set forth in claim 1 **characterised in that** the rotor (3) is mechanically rigidly connected to an engine shaft (11) of an internal combustion engine (12), in particular a gas engine, wherein the at least one rotary speed measuring device (4) communicates the at least one rotary speed signal (5) to the evaluation unit (6) for each revolution of the engine shaft (11) or a camshaft of the internal combustion engine (12).

3. A method as set forth in claim 1 or claim 2 **characterised in that** the at least one rotary speed measuring device (4) includes a sensor (4a), wherein the sensor (4a) can be arranged as desired along a periphery of the rotor (3) or along a periphery of the engine shaft (11).

4. A method as set forth in claim 3 **characterised in that** the at least one rotary speed measuring device (4) includes a signalling device (4b) co-operating with the sensor (4a), wherein the signalling device (4b) can be arranged as desired along a periphery of a stator (15) of the synchronous generator (2) or at a housing of the internal combustion engine (12).

5. A method as set forth in one of claims 1 through 4 **characterised in that** the differential time (T_{D}) is proportionally converted into degrees of rotor displacement angle (δ), wherein a value of the differential time (T_{D}) of substantially zero seconds corresponds to a rotor displacement angle (δ) of 0 degrees and a value of the differential time (T_{D}) of substantially a quarter of the period duration (2) of the voltage signal (9) of the power supply network (1) corresponds to a rotor displacement angle (δ) of 90 degrees.

6. A method as set forth in one of claims 1 through 5 **characterised in that** with a determined rotor displacement angle (δ) of more than 5 degrees, preferably more than 7 degrees, a warning signal (14) is outputted by the evaluation unit (6) to signal a threatening pole slippage.

7. A method as set forth in one of claims 1 through 6 **characterised in that** to take account of a network frequency fluctuation in respect of the voltage signal (9) of the power supply network (1) upon or during the operation of determining the time duration (T) between communication of the rotary speed signal (5) and communication of the frequency signal (10) an actual period duration of the voltage signal (9) is determined, wherein at least one correction factor formed from a predeterminable theoretical period duration fractionised by the actual period duration is determined, wherein the determined time duration (T) is multiplied by the at least one correction factor.

8. A method as set forth in claim 7 **characterised in that** the actual period duration of the voltage signal (9) is determined by measurement of a time difference between two successive frequency signals (10).

9. A method as set forth in claim 7 or claim 8 **characterised in that** a correction factor is formed upon or during the operation of determining the no-load time duration (T_{L}), wherein the no-load time duration (T_{L}) is multiplied by the correction factor and stored as a standardised no-load time duration in the evaluation unit (6).

10. A method as set forth in one of claims 7 through 9 **characterised in that** a correction factor is formed upon or during the operation of determining the differential time (T_{D}), wherein a standardised time duration is formed by multiplication of the determined time duration (T) by the correction factor, wherein to determine the rotor displacement angle (δ) a standardised differential time is formed from a standardised time duration less a standardised no-load time duration, wherein the rotor displacement angle (δ) is inferred in dependence on the standardised differential time.

## Revendications

1. Procédé de détermination d'un angle de la roue polaire (δ) d'un générateur synchrone (2) qui est raccordé électriquement à un réseau de distribution en énergie électrique (1), avec un rotor (3) ;
selon lequel au moins un mécanisme de mesure de la vitesse de rotation (4) est prévu, lequel communique au moins un signal de la vitesse de rotation (5) à une unité de traitement (6) lors d'une révolution du rotor (3), en particulier lors de chaque révolution du rotor (3) ;
selon lequel un dispositif de mesure de la fréquence (7) est prévu, lequel communique un signal de fréquence (10) à l'unité de traitement (6) à chaque durée de période (τ) d'un signal de tension (9) du réseau de distribution en énergie électrique (1) ;
selon lequel une durée de temps (T) est déterminée par l'unité de traitement (6), entre la communication du signal de la vitesse de rotation (5) et la communication du signal de fréquence (10) ;
selon lequel l'angle de la roue polaire (δ) est déduit en fonction de la durée de temps (T) déterminée ;
**caractérisé en ce que**, en vue du calibrage du procédé, la durée de temps déterminée (T) est mémorisée dans l'unité de traitement (6) sous la forme d'une durée de marche à vide (T_{L}) après la réussite de la synchronisation du générateur synchrone (2) avec le réseau de distribution en énergie électrique (1) et ce, pour l'essentiel, sans sollicitation de la charge du générateur synchrone (2) ;
selon lequel, en vue de la détermination de l'angle de la roue polaire (δ), un temps différentiel (T_{D}) est formé à partir de la durée de temps (T) déterminée, de laquelle est soustraite la durée de marche à vide (T_{L}) ; et
selon lequel l'angle de la roue polaire (δ) est déduit en fonction du temps différentiel (T_{D}).

2. Procédé selon la revendication 1, **caractérisé en ce que** le rotor (3) est raccordé de manière mécanique et rigide à un arbre de moteur (11) d'un moteur à combustion interne (12), en particulier d'un moteur à essence ;
selon lequel l'au moins un mécanisme de mesure de vitesse de rotation (4) communique à chaque résolution de l'arbre du moteur (11) ou d'un arbre à cames du moteur à combustion interne (12), l'au moins un signal de la vitesse de rotation (5) à l'unité de traitement (6).

3. Procédé selon la revendication 1 ou 2, **caractérisé en ce que** l'au moins un mécanisme de mesure de vitesse de rotation (4) comprend un capteur (4a), selon lequel le capteur (4a) peut être disposé n'importe où le long d'une circonférence du rotor (3) ou le long d'une circonférence de l'arbre du moteur (11).

4. Procédé selon la revendication 3, **caractérisé en ce que** l'au moins un mécanisme de mesure de vitesse de rotation (4) comprend un générateur de signaux (4b) qui interagit avec le capteur (4a), selon lequel le générateur de signaux (4b) peut être disposé n'importe où le long d'une circonférence d'un stator (15) du générateur synchrone (2) ou sur un carter du moteur à combustion interne (12).

5. Procédé selon l'une des revendications 1 à 4, **caractérisé en ce que** le temps différentiel (T_{D}) est converti de manière proportionnelle en degrés d'angle de la roue polaire (δ), selon lequel une valeur du temps différentiel (T_{D}) pour l'essentiel de 0 seconde correspond à un angle de la roue polaire (δ) de 0 degré et une valeur du temps différentiel (T_{D}) pour l'essentiel d'un quart de la durée de période (τ) du signal de tension (9) du réseau de distribution en énergie électrique (1) correspond à un angle de la roue polaire (δ) de 90 degrés.

6. Procédé selon l'une des revendications 1 à 5, **caractérisé en ce que**, dans le cas d'un angle de la roue polaire (δ) déterminé supérieur à 5 degrés, de préférence supérieur à 7 degrés, un signal d'avertissement (14) est émis par l'unité de traitement (6), en vue de la signalisation d'un risque de glissement des pôles.

7. Procédé selon l'une des revendications 1 à 6, **caractérisé en ce que**, en vue de la prise en compte d'une fluctuation de la fréquence du réseau du signal de la tension (9) du réseau de distribution en énergie électrique (1), une durée de période effective du signal de la tension (9) est déterminée entre la communication du signal de la vitesse de rotation (5) et la communication du signal de fréquence (10), à ou pendant la détermination de la durée de temps (T) ;
selon lequel tout au moins un facteur de correction est déterminé, lequel est formé à partir d'une durée de période théorique pouvant être prédéfinie, divisée par la durée de période effective ;
selon lequel la durée de temps (T) déterminée est multipliée par le tout au moins un facteur de correction.

8. Procédé selon la revendication 7, **caractérisé en ce que** la durée de période effective du signal de la tension (9) est déterminée par la mesure d'une différence de temps entre deux signaux de fréquence (10) successifs.

9. Procédé selon la revendication 7 ou 8, **caractérisé en ce qu'**un facteur de correction est formé à ou pendant la détermination de la durée de marche à vide (T_{L}), selon lequel la durée de marche à vide (T_{L}) est multipliée par le facteur de correction et est mémorisée dans l'unité de traitement (6) sous la forme d'une durée de marche à vide normalisée.

10. Procédé selon l'une des revendications 7 à 9, **caractérisé en ce qu'**un facteur de correction est formé à ou pendant la détermination du temps différentiel T_{D});
selon lequel une durée de temps normalisée est formée par la multiplication par le facteur de correction de la durée de temps (T) déterminée ;
selon lequel un temps différentiel normalisé est formé à partir de la durée de temps normalisée, de laquelle est soustraite la durée de marche à vide normalisée, en vue de la détermination de l'angle de la roue polaire (δ) ;
selon lequel l'angle de la roue polaire (δ) est déduit en fonction du temps différentiel normalisé.
